Europäisches Patentamt

European Patent Office

Office européen des brevets

(11) Numéro de publication: **0 306 090**
**A1**

## (12) DEMANDE DE BREVET EUROPEEN

(21) Numéro de dépôt: 88201834.4

(22) Date de dépôt: 29.08.88

(51) Int. Cl.4: **H01P 7/10 , H03L 1/00**

(30) Priorité: 04.09.87 FR 8712278

(43) Date de publication de la demande:
**08.03.89 Bulletin 89/10**

(84) Etats contractants désignés:
**DE FR GB SE**

(71) Demandeur: **RTC-COMPELEC**
**117, quai du Président Roosevelt**
**F-92130 Issy les Moulineaux(FR)**

(84) **FR**

(71) Demandeur: **N.V. Philips'**
**Gloeilampenfabrieken**
**Groenewoudseweg 1**
**NL-5621 BA Eindhoven(NL)**

(84) **DE GB SE**

(72) Inventeur: **Doyen, Daniel Societe Civile**
**S.P.I.D.**
**209, rue de l'Université**
**F-75007 Paris(FR)**
Inventeur: **Vriz, Tarcisio Societe Civile S.P.I.D.**
**209, rue de l'Université**
**F-75007 Paris(FR)**

(74) Mandataire: **Lemoyne, Didier et al**
**S.P.I.D. 209, rue de l'Université**
**F-75007 Paris(FR)**

(54) **Oscillateur hyperfréquence a résonateur diélectrique, stable par rapport aux vibrations mécaniques.**

(57) Oscillateur hyperfréquence (10) stabilisé par un résonateur diélectrique (20), comportant un boîtier (11) fermé par un couvercle (22) et comprenant un circuit (13) à résonateur diélectrique (20), fixé dans le fond (14) du boîtier (11). Selon l'invention, une colonnette (30), située dans la partie centrale (15) du boîtier (11), relie rigidement le fond (14) du boîtier (11) au couvercle (12), le résonateur diélectrique (20) étant placé hors de ladite partie centrale (15).

Application aux oscillateurs hyperfréquence à résonateur diélectrique.

FIG. 1

## OSCILLATEUR HYPERFREQUENCE A RESONATEUR DIELECTRIQUE, STABLE PAR RAPPORT AUX VIBRATIONS MECANIQUES.

La présente invention concerne un oscillateur hyperfréquence stabilisé par un résonateur diélectrique, comportant un boîtier fermé par un couvercle et comprenant un circuit à résonateur diélectrique, fixé dans le fond du boîtier.

Comme cela a été rappelé dans la demande de brevet français n° 2 587 152 déposée par la Demanderesse, le développement de nouveaux matériaux à forte constante diélectrique (Titanate de Baryum ou de Zirconium) et présentant de très faibles pertes hyperfréquence ainsi que des coefficients de température nuls ou légèrement positifs, a conduit à la réalisation d'une nouvelle génération d'oscillateurs hyperfréquence : les oscillateurs stabilisés par résonateur diélectrique. Ces oscillateurs fonctionnent à fréquence fixe ou légèrement ajustable et sont caractérisés par une grande stabilité de fréquence et de niveau de sortie en fonction de la température, un bon rendement électrique grâce à l'emploi de transistors à effet de champ, une bonne pureté de spectre et la possibilité d'utiliser la technologie des microbandes permettant un faible poids et un faible volume. Ce type d'oscillateurs trouvent de nombreuses applications en instrumentation, télécommunication, radars, etc...Dans certaines utilisations, une certaine pureté spectrale du signal hyperfréquence doit être conservée en régime de vibrations aléatoires.

Aussi, le problème technique général à résoudre pour tout oscillateur hyperfréquence stabilisé par un résonateur diélectrique est d'atténuer le plus possible l'effet des vibrations mécaniques sur la fréquence d'oscillation. La technologie de montage doit donc être adaptée à ces contraintes et, plus particulièrement, le résonateur diélectrique doit être solidement fixé sur son circuit et l'environnement métallique et diélectrique de ce résonateur doit être très rigide et stable puisque toute variation des plans métalliques ou diélectriques qui entourent le résonateur diélectrique engendre des variations de la fréquence d'oscillation. Notamment, la distance h séparant le résonateur diélectrique du couvercle du boîtier est très critique à cet égard. La Demanderesse a montré, par exemple, que, pour une distance h de 3 mm, une simple variation différentielle $\Delta h$ de quelques dizaines de $10^{-3}$ d'm provoquait une dégradation du bruit de phase d'environ 15 dB à 1 kHz de la fréquence de l'oscillateur centrée à 14 GHz. D'où l'importance de concevoir un boîtier extrêmement rigide que le seul renfort des épaisseurs métalliques ne permet pas de réaliser sauf à augmenter de façon pénalisante le poids et le volume du boîtier.

La demande de brevet français n° 2 587 152 propose comme solution au problème technique général posé de mettre le boîtier en contrainte de flexion à l'aide de moyens de portée, lorsqu'il est fixé et bloqué sur son support. Ainsi, le boîtier offre une bonne rigidité et une moindre sensibilité aux vibrations du support. Cependant, cette solution connue présente l'inconvénient d'être de mise en oeuvre délicate car elle nécessite des réglages précis notamment quant au serrage du boîtier sur lesdits moyens de portée.

Le problème technique à résoudre par l'objet de la présente demande est, précisément, de réaliser un oscillateur hyperfréquence stabilisé par un résonateur diélectrique, comportant un boîtier fermé par un couvercle et comprenant un circuit à résonateur diélectrique, fixé dans le fond du boîtier, oscillateur hyperfréquence qui serait à la fois stable par rapport aux vibrations mécaniques et de mise en oeuvre aisée.

A cet effet, la solution au problème technique posé consiste, selon la présente invention, en ce qu'une colonnette, située dans la partie centrale du boîtier, relie rigidement le fond du boîtier au couvercle, et en ce que le résonateur diélectrique est placé hors de ladite partie centrale.

De cette manière, on réduit de façon notable l'amplitude maximale des vibrations du couvercle du boîtier tout en augmentant sa fréquence de résonance. D'autre part, comme on le verra en détail plus loin, la mise en place de la colonnette est simple, sans réglages délicats.

La description qui va suivre en regard du dessin annexé, donné à titre d'exemple non limitatif fera bien comprendre en quoi consiste l'invention et comment elle peut être réalisée.

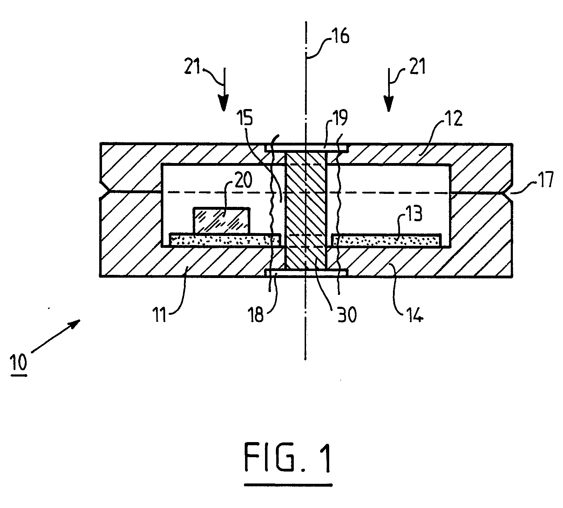

La figure 1 est une vue en coupe d'un oscillateur hyperfréquence selon l'invention.

La figure 1 montre, en coupe, un oscillateur hyperfréquence 10 stabilisé par un résonateur diélectrique 20. L'oscillateur hyperfréquence 10 de la figure 1 comporte un boîtier 11 fermé par un couvercle 12, boîtier et couvercle ayant ici une forme circulaire d'axe 16. A l'intérieur du boîtier 11 se trouve un circuit 13 à résonateur diélectrique 20 fixé dans le fond 14 dudit boîtier. Ce circuit 13 est, avantageusement, réalisé selon la technologie des microrubans sur un substrat d'alumine, par exemple. Le boîtier 11 et le couvercle 12 constituent la cavité hyperfréquence de l'oscillateur 10.

Le boîtier 11 et le couvercle 12 sont réalisés de façon très rigide afin que, sous l'effet de vibrations appliquées à l'oscillateur 10, l'environnement mécanique du résonateur diélectrique 20, qui participe à la détermination de la fréquence d'oscillation, varie le moins possible. Cependant, comme cela a été indiqué plus haut, l'oscillateur hyperfréquence 10 de la figure 1 reste néanmoins extrêmement sensible aux vibrations du support appliquées dans la direction de l'axe 16, c'est à dire perpendiculairement à la surface du circuit 13. Dans le but de diminuer cette sensibilité, il est prévu, ainsi que le montre la figure 1, qu'une colonnette 30 est située dans la partie centrale 15 du boîtier 11, c'est à dire ici dans le voisinage de l'axe 16, et relie rigidement le fond 14 du boîtier au couvercle 12. Le résonateur diélectrique 20 est alors placé hors de la partie centrale 15 du boîtier. Cette disposition permet de bloquer les vibrations dans la partie centrale du boîtier 11 et de limiter leur amplitude en dehors, là où se trouve le résonateur diélectrique 20. De la même manière, la fréquence de résonance du couvercle est augmentée.

La Demanderesse a montré expérimentalement, avec un oscillateur à résonateur diélectrique fonctionnant dans la bande Ku, qu'après avoir mesuré un bruit de -66 dBc/Hz à 1kHz de la porteuse en l'absence de vibrations, celui-ci ne valait encore que -60 dBc/Hz lorsqu'on appliquait à l'oscillateur des vibrations de 13 g dans la bande 20-2000 Hz.

De façon pratique, le trou dans le substrat d'alumine du circuit 13, nécessaire au passage de la colonnette 30, peut être réalisé par découpage laser ou par ultrasons. Le couvercle 12 est soudé sur le boîtier 11 au niveau de la gorge périphérique 17 formée par les chanfreins du couvercle et du boîtier. La colonnette 30 est ensuite mise en place par emmanchement à force, puis soudée, par soudure laser, au boîtier 11 et au couvercle 12 au niveau des parties en creux 18 et 19, respectivement. Ainsi est également assurée l'herméticité de la cavité de l'oscillateur hyperfréquence. De façon à réduire encore les vibrations, on peut, lors du montage de la colonnette 30, mettre le couvercle 12 en précontrainte en exerçant sur celui-ci une pression dans le sens des flèches 21, à l'aide par exemple d'un étrier.

**Revendications**

1. Oscillateur hyperfréquence (10) stabilisé par un résonateur diélectrique (20), comportant un boîtier (11) fermé par un couvercle (22) et comprenant un circuit (13) à résonateur diélectrique (20), fixé dans le fond (14) du boîtier (11), caractérisé en ce qu'une colonnette (30), située dans la partie centrale (15) du boîtier (11), relie rigidement le fond (14) du boîtier (11) au couvercle (12), et en ce que le résonateur diélectrique (20) est placé hors de ladite partie centrale (15).

2. Oscillateur hyperfréquence selon la revendication 1, caractérisé en ce que le couvercle (12) est en état de précontrainte.

FIG. 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | EP-A-0 214 693 (RTC-COMPELEC) * Colonne 1, lignes 28-38; colonne 2, ligne 34 - colonne 3, ligne 23; figures 1-4 * & FR-A-2 587 152 (Cat. D) | 1,2 | H 01 P 7/10 H 03 L 1/00 |
| Y | US-A-2 528 387 (NIESSEN) * Colonne 1, lignes 18-34; colonne 4, lignes 52-58 * | 1,2 | |
| A | EP-A-0 173 545 (THE UNIVERSITY OF WESTERN AUSTRALIA) * Page 1, lignes 4-9; page 2, lignes 12-19; page 4, lignes 9-16; page 5, lignes 3-13; figure * | 1,2 | |
| A | FR-A-2 534 088 (MURUTA MANUFACTURING CO.) * Page 5, ligne 30 - page 7, ligne 31; figures 5,6A,6B * | 1,2 | |
| A | US-A-4 628 283 (REYNOLDS) * Colonne 4, lignes 35-44; figure 5 * | 1 | DOMAINES TECHNIQUES RECHERCHES (Int. Cl.4) |
| A | FR-A-2 284 200 (MURATA MANUFACTURING CO.) * Page 11, lignes 3-12; figure 13 * | 1 | H 01 P H 03 B H 03 L |

Le présent rapport a été établi pour toutes les revendications

| Lieu de la recherche | Date d'achèvement de la recherche | Examinateur |
|---|---|---|
| LA HAYE | 23-11-1988 | DEN OTTER A.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)